# EUROPEAN PATENT APPLICATION

(11) **EP 2 007 180 A1**
(43) Date of publication of application: **24.12.2008**
(21) Application number: 07738587.0
(22) Date of filing: 14.03.2007
(51) Int. Cl.: H05K 3/46, H01L 21/60

(54) **CIRCUIT BOARD, ELECTRONIC CIRCUIT DEVICE, AND DISPLAY**

(30) Priority: 14.03.2006 JP 2006069892
(71) Applicant: Sharp Kabushiki Kaisha, Osaka-shi, Osaka 545-8522 (JP)
(72) Inventor: NAKAHAMA, Hiroki, Nara 630-0112 (JP); MURAOKA, Seiji, Mie 515-0818 (JP)
(74) Representative: Müller - Hoffmann & Partner
(86) International application number: PCT/JP2007/055117
(87) International publication number: WO 2007/105763

(57) **Abstract**

The present invention provides a circuit board, an electronic circuit device, and a display device, in which generation of an edge short-circuit is suppressed and wirings can be arranged more densely. The present invention is a circuit board including: a substrate having the first main surface on which a semiconductor integrated circuit is mounted and the second main surface; the first wiring including a bump connecting terminal on the first main surface; and a plurality of the second wirings on the second main surface, wherein the plurality of the second wirings are arranged independently from each other and overlap with a region where the semiconductor integrated circuit is mounted, and the circuit board includes a wiring part on the second main surface in a region overlapping with a region where the bump connecting terminal is arranged.

## Description

### TECHNICAL FIELD

The present invention relates to a circuit board, an electronic circuit device, and a display device. More specifically, the present invention relates to a circuit board on which a semiconductor integrated circuit is preferably face-down mounted. Further, the present invention relates to an electronic circuit device and a display device, each including such a circuit board.

### BACKGROUND ART

Electronic devices such as a cellular phone have been improved in performances and downsized. Therefore, components mounted on a substrate have been more densely arranged. Along with this, wirings are formed on both surfaces of a circuit board or formed as a multilayer, although the wirings had been formed on one surface. Therefore, the wirings need to be much more densely arranged.

A method of mounting a semiconductor integrated circuit (hereinafter, also referred to as an "IC chip") on a circuit board which includes wirings more densely arranged on both surfaces, particularly on the back surface, is mentioned herein.

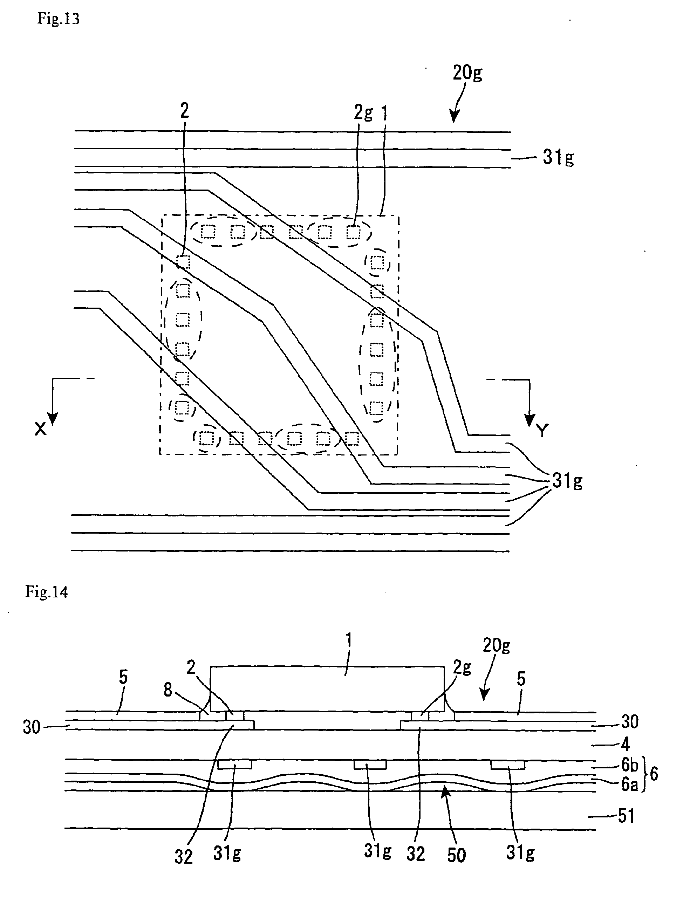

Fig. 13 is a planar view schematically showing a configuration on the second main surface (back surface) side of a conventional circuit board. In Fig. 13, the dotted line shows a bump arranged on the first main surface (front surface) and the dashed-dotted line shows an IC chip arranged on the first main surface (front surface). Fig. 14 is a cross-sectional view schematically showing a conventional circuit board in a step of mounting an IC chip on the circuit board shown in Fig. 13, and it shows a state before the IC chip is thermally pressure-bonded. Fig. 14 is a cross-sectional view taken along line XY in Fig. 13.

As shown in Fig. 13, according to a conventional circuit board 20g, a plurality of the second wirings 31g are randomly arranged in a region where the IC chip is mounted (hereinafter, also referred to as an "IC chip-mounted region"). As shown in Fig. 14, the first wiring 30 having a bump connecting terminal 32 is formed on the front surface of the circuit board 20g. The second wirings 31g are formed on the back surface. Further, an IC chip 1 is mounted on the front surface of the circuit board 20g in such a way that a bump 2 is in contact with the bump connecting terminal 32. In this case, the upper surface of the IC chip 1 is heated and pressed. As a result, the IC chip 1 is mounted on the circuit board 20g and simultaneously the first wiring 30 is electrically connected to the IC chip 1.

However, in such a conventional circuit board, an edge short-circuit is generated between the edge of the IC chip and the first wiring, and a solution for this problem has been needed. Particularly in a flexible circuit board such as a FPC (Flexible Printed Circuit) board, the edge short-circuit is more remarkably generated. In this point, the conventional circuit board has room for improvement.

Under such circumstances, Patent Documents 1 to 3 disclose inventions relating to a structure where the IC chip is connected to the wiring. Patent Document 1 discloses a technology of forming a resist to prevent a short-circuit between an IC and a pattern (wiring). However, in this technology, only one wiring can be arranged on a back surface in the IC-mounted region. Therefore, it is impossible to arrange wirings more densely.

The inventions disclosed in Patent Documents 2 and 3 do not relate to a technology of suppressing the edge short-circuit. Further, according to the invention disclosed in Patent Document 3, only one wiring is arranged on the back surface in the IC-mounted part. Also according to the invention disclosed in Patent Document 2, it is impossible to arrange wirings more densely because no wirings are arranged on the back surface in the IC-mounted part.

Thus, the conventional circuit boards have room for improvement in order to satisfy that the wirings are more densely arranged and the edge short-circuit is suppressed.
[Patent Document 1]
   Japanese Patent No. 3026205
[Patent Document 2]
   Japanese Kokai Publication No. 2004-193277
[Patent Document 3]
   Japanese Kokai Publication No. 2004-303803

### DISCLOSURE OF INVENTION

The present invention has been made in view of the above-mentioned state of the art. The present invention has an obj ect to provide a circuit board, an electronic circuit device, and a display device, in which generation of the edge short-circuit can be suppressed and wirings can be arranged more densely.

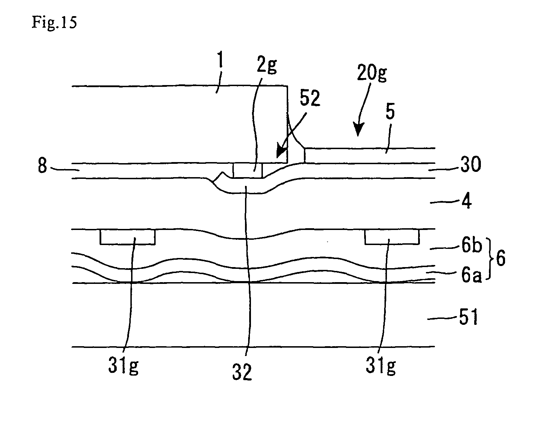

The present inventors made various investigations on a circuit board, an electronic circuit device, and a display device, in which generation of the edge short-circuit can be suppressed and wirings can be arranged more densely. The inventors noted an embodiment of wirings arranged on the surface where the IC chip is mounted and those arranged on the opposed surface of the circuit board. Then, the inventors found that the edge short-circuit is generated as follows according to the conventional circuit board. That is, according to the arrangement shown in Fig. 13, not all of the bumps 2g are overlapped by the second wirings 31g. In Fig. 13, some bumps 2g such as those shown by the broken line are not overlapped by the second wiring 31g arranged on the back surface of the circuit board. Accordingly, as shown in Fig. 14, in the IC chip-mounting step, due to the thickness (5 to 30 µm) of the second wiring 31g, a space 50 is generated between a stage 51 of a pressure bonding apparatus and a cover lay film 6 in a region which overlaps with the bump 2g and which is not overlapped by the second wiring 31g. Then, when the circuit board 20g is pressed in order for the IC chip to be thermally pressure-bonded to the circuit board 20g, as shown in Fig. 15, a circuit board 20a around the bump 2g not overlapped by the second wiring 31g is raised because of the space 50. As a result, the edge 52 of the IC chip contacts the first wiring 30 directly or through conductive particles contained in an ACF (Anisotropic Conductive Film). As a result, the edge short-circuit is generated.

The present inventors made further investigations and found that generation of the edge short-circuit can be suppressed and the wirings can be arranged more densely if a plurality of the second wirings are arranged independently from each other and overlap with a region where a semiconductor integrated circuit is mounted and the circuit board includes a wiring part on the second main surface in a region overlapping with a region where a bump connecting terminal is formed. As a result, the above-mentioned problems have been admirably solved, leading to completion of the present invention.

That is, the present invention is a circuit board including: a substrate having the first main surface on which a semiconductor integrated circuit is mounted and the second main surface; the first wiring including a bump connecting terminal on the first main surface; and a plurality of the second wirings on the second main surface, wherein the plurality of the second wirings are arranged independently from each other and overlap with a region where the semiconductor integrated circuit is mounted, and the circuit board includes a wiring part on the second main surface in a region overlapping with a region where the bump connecting terminal is arranged (hereinafter, also referred to as "the first circuit board of the present invention"). The first circuit board of the present invention is mentioned below.

The first circuit board of the present invention includes the first main surface on which a semiconductor integrated circuit is mounted and the second main surface, wherein the first wiring including a bump connecting terminal is formed on the first main surface and the second wirings are formed on the second main surface. Thus, the first circuit board of the present invention is a double-sided substrate or a multilayer substrate on which the IC chip is mounted. The method of mounting the IC chip is not especially limited. The IC chip is bare chip-mounted by a COF (Chip On Film) method, commonly.

The first circuit board of the present invention may be a multilayer board including wirings formed in a plurality of layers. In this case, the first main surface is a surface of the first layer, and the second main surface is a surface of the second layer (the boundary surface between the first layer and the second layer). Accordingly, in this case, the first wiring functions as the first-layer wiring, and the second wiring functions as the second-layer wiring. The first layer means a layer on which the IC chip is mounted and it is commonly the outermost layer. Starting from the layer closest to the first layer, the layers are defined as the second layer, third layer, and the like. If the circuit board of the present invention is a multilayer substrate, the embodiment of the fourth or higher layers is not especially limited and it may be appropriately determined.

The above-mentioned bump connecting terminal is a terminal for electrically connecting the first wiring to the bump of the IC chip. Accordingly, the bump connecting terminal generally has substantially the same arrangement as that of the bump of the IC chip. It is preferable that the bump connecting terminal is integrally formed with the first wiring in view of simplification of the production processes. That is, it is preferable that the first wiring includes the bump connecting terminal. The bump is a projective electrode with which the IC chip is provided. The bump connects the IC chip to an external circuit.

The above-mentioned plurality of the second wirings are arranged independently from each other and overlap with the region where the semiconductor integrated circuit is mounted. The above-mentioned "the plurality of the second wirings are arranged to overlap with the IC chip-mounted region" means that the plurality of the second wirings exist in the IC chip-mounted region when the circuit board is viewed in plane from the first or second surface side (hereinafter, also described that "when the circuit board is viewed in plane"). The above-mentioned "the plurality of the second wirings are arranged independently from each other" means that the plurality of the second wirings are arranged without being electrically connected to each other within the IC chip-mounted region. As a result, the wirings can be arranged more densely on the circuit board, according to the first circuit board of the present invention. The distance among the plurality of the second wirings is not especially limited. The distance is preferably 10 µm or more and more preferably 20 µm or more in the IC chip-mounted region in order to suppress generation of the short-circuit among the plurality of the second wirings. If the distance among the plurality of the second wirings is 10 µm or less, when the second wirings are formed by wet etching, the wiring might remain between the second wirings (due to insufficient etching, a material for the wiring remains between the wirings). As a result, the short-circuit might be generated between the second wirings.

Not all of the second wirings arranged on the second main surface need to overlap with the IC chip-mounted region. Accordingly, among all of the second wirings formed on the second main surface, two or more of the second wirings may be appropriately arranged to overlap with the IC chip-mounted region, depending on a desired design. The two or more of the second wirings may be or not may be connected to each other outside the IC chip-mounted region.

The above-mentioned circuit board includes a wiring part on the second main surface in the region overlapping with the region where the bump connecting terminal is arranged. That is, the above-mentioned circuit board includes a wiring part on the second main surface in a region overlapping with the region where the bump is arranged when the IC chip is mounted. In the IC chip-mounting step, the wiring part has a function of filling a space generated between the circuit board and the stage of the pressure bonding apparatus in the region overlapping with the bump. As a result, generation of the edge short-circuit can be suppressed according to the first circuit board of the present invention. Thus, it is preferable that the wiring part is formed to overlap with two or more of the above-mentioned bump connecting terminals (a region corresponding to two or more of the above-mentioned bump connecting terminals) when the circuit board is viewed in plane.

If the second wiring is arranged to overlap with a part of the region where the bump connecting terminal is formed, the wiring part may be arranged in a region where the second wiring is not arranged in the region where the bump connecting terminal is arranged. It is preferable that the wiring part does not overlap with the second wiring. Not all of the regions overlapping with the region where the bump connecting terminal is formed on the second main surface are overlapped by the wiring part. However, in order to more effectively suppress generation of the edge short-circuit, it is preferable that the circuit board includes the wiring part in substantially all of the regions overlapping with the region where the bump connecting terminal is arranged on the secondmain surface. That is, it is preferable that the above-mentioned circuit board includes the wiring part in substantially all of the regions overlapping with the region where the bump is arranged when the IC chip is mounted on the second main surface. Accordingly, from these viewpoints, it is preferable in the above-mentioned circuit board that every bump connecting terminal (every region corresponding to the bump connecting terminal) is overlapped by either the second wiring or the wiring part when the above-mentioned circuit board is viewed in plane. From the same viewpoints, the following embodiment may be mentioned: every bump connecting terminal (every region corresponding to the above-mentioned plurality of bump connecting terminals) is not overlapped by any one of the second wirings, but overlapped by the wiring part when the circuit board is viewed in plane.

The first circuit board of the present invention is not especially limited as long as it essentially includes such components. The first circuit board may or may not include other components.

According to the first circuit board of the present invention, as mentioned above, the plurality of the second wirings are optionally arranged in the region where the semiconductor integrated circuit is mounted, and simultaneously the wiring part is formed to cover each part where the bump is pressed in the IC chip-mounting step, other than the region where the second wiring is arranged. Accordingly, the wirings can be more densely arranged, and the pressure which is applied to each bump in the IC chip-mounting step can be excellently balanced. As a result, generation of the edge short-circuit can be suppressed. Thus, the first circuit board of the present invention includes a circuit board including a substrate having the first main surface on which a semiconductor integrated circuit is mounted and the second main surface, wherein the circuit board includes: a plurality of bump connecting terminals formed in a region where the semiconductor integrated circuit is mounted; and a plurality of the first wirings connected to the plurality of bump connecting terminals, respectively, on the first main surface side, the circuit board further includes: a plurality of the second wirings formed to pass through the region where the semiconductor integrated circuit is mounted (independently from each other) when the circuit board is viewed in plane; and a wiring part on the second main surface side, and the wiring part is arranged to overlap with the plurality of bump connecting terminals (a region corresponding to the plurality of bump connecting terminals) when the circuit board is viewed in plane.
Preferable embodiments of the first circuit board of the present invention are mentioned below in more detail.

The shape of the above-mentioned wiring part is not especially limited. For sufficient exhibition of the effects of the present invention, it is preferable that the thickness of the wiring part and the thickness of the second wirings are uniformed. Thus, it is preferable that the wiring part and the second wirings have the same or substantially the same thickness. Further, it is preferable that the wiring part and the second wirings are made of the same or substantially the same material. Accordingly, the wiring part and the second wiring which are the same in thickness can be simply formed in the same process. In the present description, the "two different members have substantially the same thickness" means that the same thickness can be attained when the two different members are formed in the same process. Further, the thickness may be different between the two different members as long as the difference is within a degree of difference which can be generated even if the two different members can be formed in the same process. More specifically, the difference in thickness between the wiring part and the second wiring is preferably 6 µm or less and 3 µm or less. As a result, the operation and effects of the present invention are sufficiently exhibited.

Preferable embodiments of the above-mentioned wiring part include an embodiment (1) in which the wiring part is connected to any one or more of the plurality of the second wirings and an embodiment (2) in which the wiring part is a dummy wiring independent from the plurality of the second wirings. Such a dummy wiring independent from the second wiring means a dummy wiring which is not electrically connected to the second wiring. The dummy wiring means an electrically insulated wiring which is not connected to an external circuit. According to the above-mentioned embodiment (1), generation of the edge short-circuit can be more effectively suppressed. According to the embodiment (1), the method of connecting the second wiring to the wiring part is not especially limited. An embodiment in which the second wirings and the wiring part are integrally formed is preferable. According to this embodiment, the above-mentioned embodiment (1) can be easily realized.

According to the above-mentioned embodiment (2), the short-circuit can be suppressed from being generated among the plurality of the second wirings through the wiring part. According to the above-mentioned embodiment (2), in order to effectively suppress generation of the edge short-circuit, it is preferable that the distance between the wiring part and the second wiring is not larger than the distance between the bump connecting terminals. Further, it is preferable that the distance between the wiring part and the second wiring is not larger than the distance between the bumps of the mounted IC. More specifically, according to the above-mentioned embodiment (2), the distance between the wiring part and the second wiring is preferably 50 µm or less and more preferably 30 µm or less. The first circuit board of the present invention may have an embodiment in which some of the wiring parts are connected to the second wirings, respectively, and the other wiring parts are not connected to any of the second wirings.

The embodiment of the above-mentioned bump connecting terminal may be appropriately designed depending on the bump of the mounted IC chip. According to the first circuit board of the present invention, it is preferable that a plurality of the bump connecting terminals are arranged in a plurality of lines along a boundary of the region where the semiconductor integrated circuit is mounted, the circuit board includes a through-hole, and an innermost circumference bump connecting terminal is connected to any one of the plurality of the second wirings through the through-hole (hereinafter, also referred to as "the first embodiment"). As a result, the wirings can be more densely arranged and therefore a smaller IC chip can be mounted on the circuit board of the present invention. The embodiment of the through-hole is not especially limited as long as the bump connecting terminal on the first main surface is connected to the second wiring on the second main surface. An embodiment in which an opening formed in the substrate is filled with a conductive substance and an embodiment in which a conductive substance is arranged on an inner wall surface of an opening formed in the substrate. The embodiment of the opening is not especially limited, and the opening may have a cylinder, elliptic cylinder, rectangular parallelepiped shape, for example.

According to the above-mentioned first embodiment, the following embodiments (a) and (b) are preferable. An embodiment (a) in which the bump connecting terminals are arranged in two or more lines and in a staggered pattern and an embodiment (b) in which the through-hole is arranged on the inside of the innermost circumference bump connecting terminal. According to the above-mentioned embodiment (a), the plurality of the bump connecting terminals are arranged in two or more lines and in a staggered pattern. Therefore, generation of defects such as short-circuit between the inner bump connecting terminal and the outer bump connecting terminal can be suppressed. While the short-circuit can be suppressed from being generated between the inner bump connecting terminal and the outer bump connecting terminal, the bump connecting terminals can be arranged more densely. According to the above-mentioned embodiment (b), the short-circuit between the first wirings which are more densely arranged and the through-holes can be prevented.
Simultaneously, the space between the through-holes can be sufficiently secured.

The present invention is also a circuit board including: a substrate having the first main surface on which a semiconductor integrated circuit is mounted and the second main surface; the first wirings including bump connecting terminals, respectively, on the first main surface; and a plurality of the second wirings on the second main surface, wherein the plurality of the second wirings are arranged independently from each other and overlap with a region were the semiconductor integrated circuit is mounted, the circuit board includes wiring parts on the second main surface side in a region where the bump connecting terminals are arranged, and the wiring parts are arranged at a distance from one another, the distance being not larger than a distance between the bump connecting terminals (hereinafter, also referred to as "the second circuit board of the present invention").
The second circuit board of the present invention is mentioned below. The second circuit board of the present invention is different from the first circuit board of the present invention just in the embodiment of the wiring part. Therefore, explanation for the same components is omitted.

According to the second circuit board of the present invention, the above-mentioned circuit board includes wiring parts on the second main surface in regions where the bump connecting terminal is arranged. That is, the above-mentioned circuit board includes wiring parts on the second main surface in regions where a bump is arranged when an IC chip is mounted. Thus, the wiring parts are arranged along the boundary of the IC chip-mounted region, normally.

According to the second circuit board of the present invention, a plurality of the above-mentioned wiring parts are arranged at a distance from one another, and the distance is not larger than a distance between the bump connecting terminals. As a result, the circuit board normally has a certain strength, and therefore, generation of the edge short-circuit can be suppressed according to the second circuit board of the present invention. In the present description, the distance means the shortest distance between adjacent two objects, that is, the minimum length of the space between adjacent two objects. If an IC chip including plated bumps having a straight shape (so-called straight plated bump) such as an Au-plated bump is mounted, the bumps can be formed at a fine pitch, and therefore, the distance between the bump connecting terminals is larger than a distance between the bumps of the IC chip mounted on the circuit board. Accordingly, it is preferable that a plurality of the wiring parts are arranged at a distance from one another and the distance is not larger than a distance between the bumps when the IC chip is mounted. If an IC chip including stud bumps is mounted, the distance between the bump connecting terminals is normally smaller than the distance between the bumps of the IC chip mounted on the circuit board. Accordingly, in this case, generation of the edge short-circuit can be more sufficiently suppressed if the plurality of the wiring parts are arranged at a distance from one another and the distance is not larger than the distance between the bump connecting terminals. The stud bump can be formed in the following manner, for example. A ball-shaped Au which is formed by fusion discharge of the tip of an Au wire is jointed to an IC pad by heat and ultrasonic waves, and after that, the wire is cut. The length of the stud bump can be uniformed by leveling. Thus, it is preferable that the wiring parts are arranged at a distance from one another, and the distance is not larger than the distance between the bump connecting terminals, in a region overlapping with two or more of the above-mentioned bump connecting terminals (a region corresponding to two or more of the bump connecting terminals) when the circuit board is viewed in plane.

The embodiment of the above-mentioned wiring part is not especially limited. The following embodiments (A) and (B) are preferable: an embodiment (A) in which the wiring parts are arranged in a dot pattern; and an embodiment (B) in which the wiring parts are provided with a slit. According to these embodiments, the second circuit board of the present invention can be produced.

The distance between the above-mentioned wiring parts is not especially limited as long as it is not larger than the distance between the bump connecting terminals. More specifically, the distance between the wiring parts is preferably 50 µm or less and more preferably 30 µm or less. According to this, generation of the edge short-circuit can be more effectively suppressed even if the IC chip including bumps arranged at a fine pitch of 100 µm or 60 µm is mounted on the second circuit board of the present invention. In this description, the pitch means a distance between opposing two points of adjacent two objects.

According to the second circuit board of the present invention, the distance between the wiring parts may be substantially the same as the distance between the bump connecting terminals. The wiring part may or may not be arranged in the entire region where the bump connecting terminal is arranged on the second main surface side. That is, the wiring part may or may not be arranged to overlap with the entire of the above-mentioned bump connecting terminal (a region corresponding to the entire of the above-mentioned bump connecting terminal) when the above-mentioned circuit board is viewed in plane.

The configuration of the second circuit board of the present invention is not especially limited. The second circuit board may or may not include other components as long as it essentially includes such components.

As mentioned above, according to the second circuit board of the present invention, a plurality of the second wirings are optionally arranged in the region where the semiconductor integrated circuit is mounted; and the wiring parts are formed at a distance from one another; and the distance is not larger than a distance between the bumps within the region overlapping with the part pressed by the bump in the IC chip-mounting step, other than the region where the second wiring is arranged. As a result, the wirings can be more densely formed, and the pressure on each bump can be excellently balanced in the IC chip-mounting step. Then, generation of the edge short-circuit can be suppressed. Thus, the second circuit board of the present invention is a circuit board including a substrate having the first main surface on which a semiconductor integrated circuit is mounted and the second main surface, wherein the circuit board includes: a plurality of bump connecting terminals formed in a region where the semiconductor integrated circuit is mounted; and a plurality of the first wirings connected to the plurality of bump connecting terminals, respectively, on the first main surface side, the circuit board further includes: a plurality of the second wirings formed to pass through the region where the semiconductor integrated circuit is mounted (independently from each other) when the circuit board is viewed in plane; and a plurality of wiring parts on the second main surface side, and the plurality of wiring parts are arranged at a distance from one another in a region overlapping with the plurality of bump connecting terminals (a region corresponding to the plurality of bump connecting terminals) when the circuit board is viewed in plane, the distance being not larger than a distance between the bump connecting terminals.

Other embodiments mentioned about the first circuit board of the present invention are appropriately applied to the second circuit board of the present invention. It is preferable in the second circuit board of the present invention that some of the wiring parts are not connected to the second wirings in order to easily design the arrangement of the wiring part. More specifically, it is preferable that the wiring parts other than those adjacent to the second wirings are not connected to the second wiring.

The first and second circuit boards of the present invention may be combined according to the present invention.

The present invention is also a circuit board including: a substrate having the first main surface on which a semiconductor integrated circuit is mounted and the second main surface; the first wirings including bump connecting terminals, respectively, on the first main surface; and a plurality of the second wirings on the second main surface, wherein each of the bump connecting terminals is overlapped by any one or more of the plurality of the second wirings (hereinafter, also referred to as "the third circuit board").
The third circuit board of the present invention is mentioned below. The third circuit board of the present invention is different from the first circuit board of the present invention, just in the embodiments of the second wiring and the wiring part. Therefore, the explanation for the same components is omitted.

According to the third circuit board of the present invention, each of the bump connecting terminals is overlapped by any one or more of the plurality of the second wirings. That is, every bump is overlapped by any one or more of the second wirings when the IC is mounted. As a result, generation of the edge short-circuit can be suppressed without wiring parts according to the third circuit board of the present invention. The above-mentioned "each of the bump connecting terminals is overlapped by any one or more of the plurality of the second wirings" means that the plurality of the second wirings exist to overlap with all of the bump connecting terminals (each of the bump connecting terminals is overlapped by any one or more of the plurality of the second wirings when the circuit board is viewed in plane.

The configuration of the third circuit board of the present invention is not especially limited. The third circuit board may or may not include other components as long as it essentially includes such components.

As mentioned above, according to the third circuit board of the present invention, every part pressed by the bump in the IC chip-mounting step is overlapped by any one or more of the plurality of the second wirings in the region where the semiconductor integrated circuit is mounted. Accordingly, the wirings can be more densely arranged, and the pressure on each bump in the IC chip-mounting step can be excellently balanced. As a result, generation of the edge short-circuit can be suppressed. Thus, the third circuit board of the present invention may be a circuit board including a substrate having the first main surface on which a semiconductor integrated circuit is mounted and the second main surface, wherein the circuit board includes: a plurality of bump connecting terminals formed in a region where the semiconductor integrated circuit is mounted; and a plurality of the first wirings connected to the plurality of bump connecting terminals, respectively, on the first main surface side, the circuit board further includes a plurality of the second wirings formed to pass through the region where the semiconductor integrated circuit is mounted (independently from each other) when the circuit board is viewed in plane, and each of the plurality of bump connecting terminals (each of the region corresponding to the plurality of bump connecting terminals) is overlapped by any one of the plurality of the second wirings when the circuit board is viewed in plane.

Other embodiments mentioned in detail about the first circuit board of the present invention can be appropriately applied to the third circuit board of the present invention.

The present invention is also an electronic circuit device including: any one of the first to third circuit boards of the present invention; and a semiconductor integrated circuit including a bump connected to the bump connecting terminal (hereinafter, also referred to as an "electronic circuit device of the present invention"). According to the circuit board included in such an electronic circuit device, generation of the edge short-circuit can be suppressed and the wirings can be more densely arranged. Therefore, generation of the defects in the electronic circuit device can be reduced and further the electronic circuit device can be downsized.

The present invention is a display device including the electronic circuit device of the present invention. According to this, generation of the defects in the electronic circuit device can be reduced and further the electronic circuit device can be downsized. Therefore, generation of defects in the display device can be reduced and the display device can be downsized.

### EFFECT OF THE INVENTION

According to the circuit board of the present invention, generation of edge short-circuit can be suppressed and the wirings can be arranged more densely. According to the electronic circuit device and the display device of the present invention, generation of the defects in such devices can be reduced and further those devices can be downsized.

### BEST MODES FOR CARRYING OUT THE INVENTION

The present invention is mentioned in more detail below with reference to Embodiments, but not limited to only these Embodiments. The present invention in accordance with the following Embodiments is mentioned with reference to a liquid crystal display device. However, in addition to the liquid crystal display device, the display device of the present invention can be applied to various display devices, such as an organic electroluminescent (EL) display device, an inorganic EL display device, a plasma display panel (PDP), a vacuum fluorescent display (VFD) device, and an electronic paper. The circuit board and the electronic circuit device of the present invention can be applied to various electronic apparatuses such as a cellular phone, a PDA (Personal Digital Assistant) and OA equipment, in addition to the display device.

### "Embodiment 1"

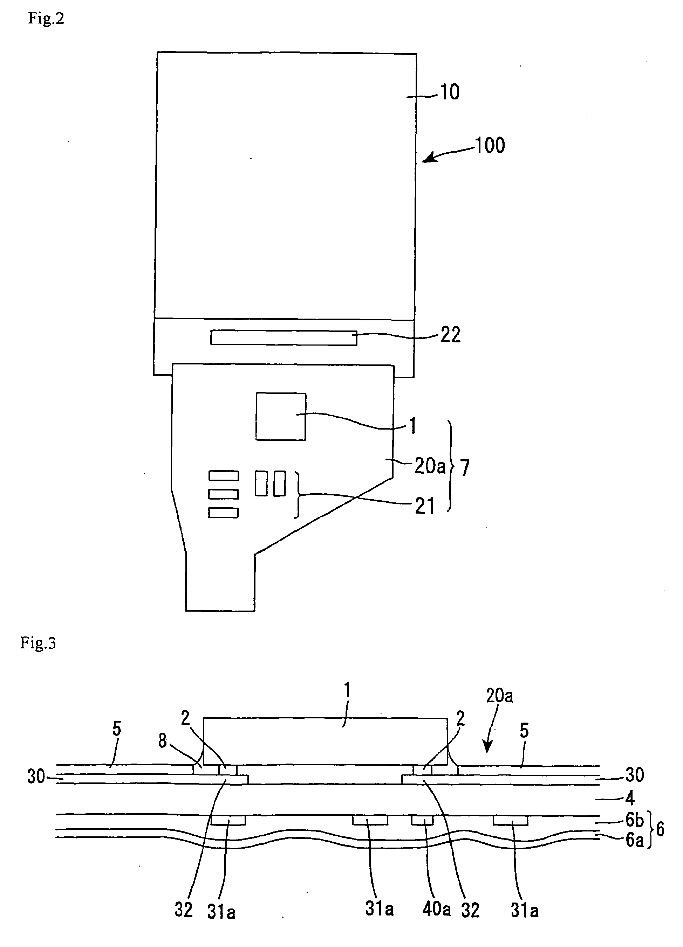

A liquid crystal display device in accordance with Embodiment 1 of the present invention is mentioned. Fig. 2 is a planar view schematically showing the liquid crystal display device in accordance with the present embodiment.

A liquid crystal display device 100 includes a liquid crystal display panel 10 and an electronic circuit device 7 connected to an edge of the liquid crystal display panel 10.

The liquid crystal display panel 10 includes: an element substrate including switching elements; a counter substrate facing the element substrate; and a liquid crystal layer interposed between the both substrates. The counter substrate includes a common electrode and a color filter layer. The common electrode is arranged over almost the entire display region of the counter substrate. The liquid crystal layer is constituted by a nematic liquid crystal material with electrical optical characteristics.

The element substrate includes a plurality of gate wirings, a plurality of source wirings, TFTs, and pixel electrodes. The plurality of gate wirings are arranged in parallel on the substrate. The plurality of source wirings are arranged in parallel and they are perpendicular to the plurality of gate wirings. The TFTs are arranged at intersections of the plurality of the gate wirings with the plurality of the source wirings. The pixel electrodes are arranged to correspond to the TFTs, respectively.

The liquid crystal display panel 10 has a driver 22 which is bare chip-mounted on the substrate in a COG (Chip On Glass) method.

A gate driver, a source driver, and the like are mentioned as the driver 22. The gate driver has a function of increasing an electrical potential of only selected gate wiring and sending a gate signal to other gate wirings to maintain them at a low electrical potential.

The source driver has a function of converting received image data into a voltage (signal voltage) to be applied to a liquid crystal capacitance and applying this signal voltage to the pixel electrode through a selected source wiring.

Thus, according to the liquid crystal display panel 10, one pixel electrode constitutes one pixel. In each pixel, a gate signal is sent from the gate driver through the gate wiring and thereby the TFT is switched into an on-state. When the TFT is switched into an on-state, a specific source signal is sent from the source driver through the source wiring, and a charge is written into the pixel electrode. Then, a voltage applied to a liquid crystal capacitance generated between the pixel electrode and the common electrode is controlled. Thereby, an alignment state of liquid crystal molecules in the liquid crystal layer is changed to adjust a light transmittance. In such a manner, images are displayed.

The electronic circuit device 7 includes a circuit board 20a, an IC chip 1, and a chip electronic component 21.

The IC chip 1 is bare chip-mounted on the circuit board 20a by a COF (Chip On Film) method. The IC chip 1 includes bumps 2 as a projective bump electrode for bonding. This IC chip 1 corresponds to a controller IC, a power IC, and the like, of the liquid crystal display device in accordance with the present Embodiment. The external size of the IC chip 1 is 5 mm in length, 5 mm in width, and 400 µm in height, for example.

A plurality of bumps 2 are arranged on the outer periphery of the bottom surface of the IC chip 1 to project in the normal direction of the IC chip 1. Each of such bumps 2 has an Au-plated surface and serves as an input and output terminal. Thus, the bump 2 is a so-called straight plated bump. The external size of the bump 2 is, for example, 60 µm in length, 40 µm in width (in pitch direction), 15 µm in height. The distance between the bumps 2 is 20 µm, and the pitch between the bumps 2 is 60 µm, for example.

The controller IC generates a control signal for operating the source driver and the gate driver, or controls timing of polarity inversion in a standard power circuit.

The power IC converts an input alternating voltage into an optimal voltage depending on an object to be driven such as the source driver, the gate driver, and the controller IC.

The chip electronic component 21 is an electronic component on the periphery of the liquid crystal display panel 10 such as a resistor and a ceramic condenser.

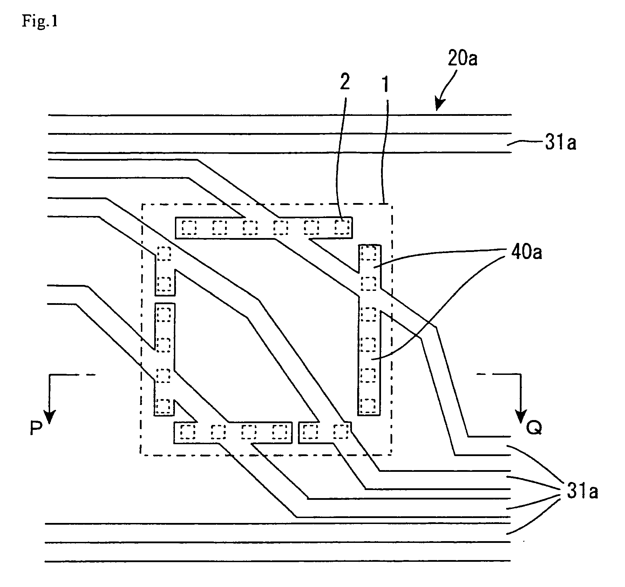

Fig. 1 is a planar view schematically showing a configuration on the second main surface (back surface) side in an IC chip-mounted region and near the IC chip-mounted region of the electronic circuit device in accordance with Embodiment 1. In Fig. 1, the dotted line shows a bump arranged on the first main surface (front surface) and the dashed-dotted line shows an IC chip arranged on the first main surface (front surface). Fig. 3 is a cross-sectional view schematically showing the electronic circuit device in accordance with Embodiment 1, taken along line PQ in Fig. 1.

The circuit board 20a includes a base film having an insulating property (substrate) 4, the first wirings 30, the second wirings 31a, wiring parts 40a, and a cover lay film 6 arranged to cover the second wirings 31a and the wiring parts 40a.

The base film 4 is a flexible film mainly including polyimide. The cover lay film 6 is composed of an insulating film 6a that is a polyimide film and the like and a cohesive layer 6b. The base film 4 is a film made of glass epoxy, a liquid crystal polymer, and the like.

The first wiring 30 is arranged on the first main surface (front surface) on which an IC chip 1 is mounted of the base film 4. The first wiring 30 connects the IC chip 1 to a connector for input signal (not shown), the liquid crystal display panel 10 and the like. In an IC chip-mounted region where the IC chip 1 is mounted, a bump connecting terminal 32 for connecting the bump 2 of the IC chip 1 to the first wiring 30 is arranged. Further, on the first main surface (front surface) of the base film 4, an insulating resist 5 made of an epoxy resin and the like is arranged to overlap with the first wiring 30. The bump connecting terminal 32 is formed by subjecting the end of the first wiring 30, extended to the IC chip-mounted region, to Ni plating treatment and further subjecting the Ni-plated end to Au plating treatment.

The secondwiring 31a is arranged on the secondmain surface (back surface) opposite to the base film 4 surface on which the IC chip 1 is mounted. The second wiring 31a is a part of the first wiring 30, which takes a detour to the back face, in order to prevent the first wirings 30 from crossing with each other on the front surface of the base film 4 and simultaneously arrange the wirings more densely. The size of the second wiring is 50 µm in width and 17 µm in thickness, for example.

As shown in Fig. 1, a plurality of the second wirings 31a are arranged independently from each other and overlap with the IC chip-mounted region at a distance of 30 µm or more from one another. That is, the plurality of the second wirings 31a are arranged to pass through the IC chip-mounted region independently from each other when the circuit board a is viewed in plane. As a result, the wirings can be more densely arranged.

As shown in Fig. 13, in the IC chip-mounting step, the wiringpart 40a has a function of filling a space generated between the circuit board and a stage of a pressure bonding apparatus in the region overlapping with the bump. The wiring part 40a is formed on the second main surface of the circuit board 20a in a region overlapping with the region where the bump 2 is arranged. That is, the wiring part 40a is formed on the second main surface side of the circuit board 20a to cover the bump 2 when the circuit board 20a is viewed in plane. The wiring part 40a and the second wiring 31a are integrally formed to be connected to each other. The wiring part 40a and the second wiring 31a are substantially the same in the width and the thickness.

Thus, in every region which overlaps with the bump 2, the second wiring 31a or the wiring part 40a is arranged. In the IC chip-mounting step, no space is generated in the region which overlaps with the bump 2. Accordingly, the circuit board 20a is suppressed from being raised when the IC chip is thermally pressure-bonded. As a result, generation of the edge short-circuit can be suppressed. Thus, according to the present Embodiment, either the second wiring 31a or the wiring part 40a is arranged in the region overlapping with the bump 2. As a result, generation of the edge short-circuit can be effectively suppressed. That is, in the present Embodiment, every bump connecting terminal 32 is overlapped by either the second wiring 31 or the wiring part 40 when the circuit board 20a is viewed in plane.

If the wiring part 40a is formed, the second wiring 31a is not necessarily arranged to overlap with the bump 2. Accordingly, the second wiring 31a is freely arranged, and therefore the circuit board 20a can be more freely designed.

Further, if there is a space in the region which overlaps with the bump 2, sufficient load is not applied to the bump 2 when the IC chip is thermally pressure-bonded in the IC chip-mounting step. As a result, disconnection between the bump 2 and the bump connecting terminal 32 might be generated. However, in the liquid crystal display device in accordance with the present Embodiment, every region overlapping the bump 2 is overlapped by either the second wiring 31a or the wiring part 40a. Therefore, generation of the disconnection can be effectively suppressed.

The production method of the circuit board 20a is exemplified below. A subtractive method, an additive method, and the like are mentioned as a production method of the circuit board 20a.

If the circuit board 20a is prepared using a subtractive method, a multilayer substrate composed of copper/polyimide (the base film 4) /copper is prepared by a casting method and the like, first. The casting method is, for example, a method of applying a polyimide precursor solution on a copper foil; drying and curing the solution; and thereby forming a multilayer substrate composed of copper/polyimide.

Then, the copper layer on one surface (front surface) of the obtained multilayer substrate composed of copper/polyimide/copper is patterned by a photolithography process (Photo Engraving Process, hereinafter, also referred to as "PEP process"). The bump connecting terminal 32 and the first wiring 30 are integrally formed in such a way that the bump connecting terminal 32 is positioned in the IC chip-mounted region.

Then, the copper layer on the other surface (back surface) of the multilayer substrate composed of copper/polyimide/copper is patterned by the PEP process. As a result, a plurality of the second wirings 31a and the wiring parts 40a are formed in accordance with the above-mentioned arrangement.

If the circuit board 20a is prepared by an additive method, first, a resist is formed on the front and back surfaces of polyimide (the base film 4) in a region other than the region where the wiring is formed.

Then, this is immersed into an aqueous solution of a mixture of a metal salt with a reducing agent, and thereby the polyimide surfaces are electroless-plated. In this manner, the metal salt is reduced and the metal is deposited to form a metal layer in the region where the wiring is formed.

Then, copper is further formed on the metal layer by common electroplating, and then the resist is removed. As a result, the bump connecting terminals 32, the first wirings 30, the second wirings 31a, and one or more wiring parts 40a are formed in accordance with the above-mentioned arrangement.

For the thus-prepared substrate, a resist 5 is applied on the surface of the multilayer substrate by a printing method to cover the first wirings 30 except for a region where the bump connecting terminal 32 is arranged within the IC chip-mounted region. In this case, the part which is not covered with the resist 5 of the first wiring 30 constitutes the bump connecting terminal 32. Then, the bump connecting terminal 32 surface is subjected to Ni plating treatment and Au plating treatment.

Then, a cover lay film 6 that is a multilayer composed of the insulating film 6a and the cohesive layer 6b is attached to the back surface of the multilayer substrate to cover the second wirings 31a.

In the above-mentioned manner, the circuit board 20a of the present invention is produced.

Then, a method for producing an electronic circuit device 7 by mounting the IC chip 1 and the chip electronic component 21 on the circuit board 20a is mentioned below.

According to the present Embodiment, using a commonmethod, the bump 2 of the IC chip 1 and the bump connecting terminal 32 on the circuit board 20a are connected to each other through an ACF (Anisotropic Conductive Film) 8, and then the chip electronic component 21 is connected.

The method of connecting the bump 2 of the IC chip to the bump connecting terminal 32 on the circuit board 20a using the ACF 8 is mentioned below.

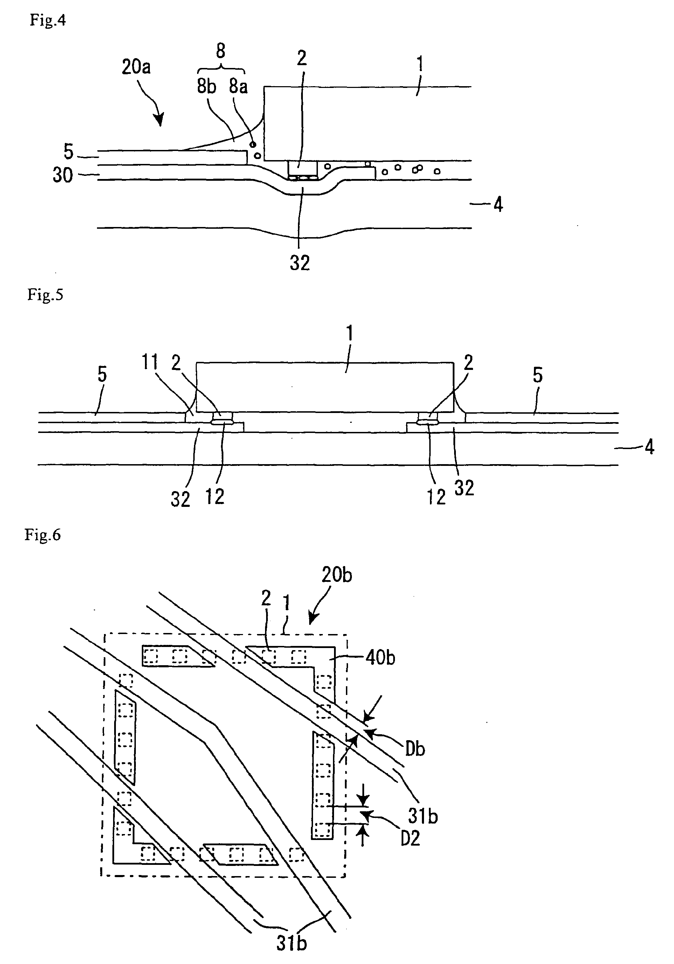

Fig. 4 is a cross-sectional view schematically showing a structure near the edge of the IC chip in the electronic circuit device in accordance with Embodiment 1, and shows an embodiment where the IC chip is connected to the circuit board with the ACF. Components which are not referred to are not illustrated.

First, the ACF 8 is attached to the circuit board 20a to cover the bump connecting terminal 32. Successively, the bump connecting terminal 32 is aligned with the bump 2 of the IC chip 1. Then, the IC chip 1 is heated and pressed (thermally pressure-bonded) with a tool (not shown), thereby connecting the bump 2 to the bump connecting terminal 32. The ACF 8 is prepared by dispersing conductive particles 8a that are plastic beads plated with Ni, Au, and the like, into an adhesive 8b that is a film made of an epoxy resin and the like. This ACF 8 is heated and pressed at 180 to 210°C. As a result, the conductive particles 8a are pressed between the bump 2 of the IC chip 1 and the bump connecting terminal 32. The bump 2 is electrically connected to the bump connecting terminal 32. Simultaneously, the adhesive 8b is thermally cured, and thereby the part where the bump 2 is connected to the bump connecting terminal 32 is fixed. In such a manner, the IC chip is mounted on the circuit board 20a.

A method of connecting the chip electronic component 21 to the circuit board 20a where the IC chip 1 is mounted is mentioned below.

A connecting terminal (not shown) for mounting the chip electronic component 21, arranged on the circuit board 20a, is coated with cream solder (creamy mixture containing solder powder, solvent, and flux) by a printing method, a dispenser method, and the like.

Then, the circuit board 20a is aligned with the chip electronic component 21, and the chip electronic component 21 is mounted.

Then, the circuit board 20a including the chip electronic component 21 is put into a reflow furnace at about 230 to 260°C, and thereby the cream soldering is melted (reflow heating step).

In the reflow heating step, moisture which is contained in the ACF 8 interposed between the IC chip 1 and the base film 4 is heated and tries to blow out to the outside in the form of vapor. According to the circuit board 20a in the present Embodiment, there is a region where neither the wiring part 40a nor the second wiring 31a are arranged in the IC chip-mounted region. The vapor passes through the base film 4 and the cover lay film 6 in this region to be released to the outside. Thus, according to the present Embodiment, the disconnection between the bump 2 and the bump connecting terminal 32, caused by the vapor blowout in the reflow heating step, can be prevented.

Then, the cream soldering is cooled and cured. As a result, the chip electronic component 21 is electrically connected to the circuit board 20a.

The electronic circuit device 7 in accordance with the present Embodiment is produced. Further, the liquid crystal display device 100 in the present Embodiment is produced by connecting the liquid crystal display panel 10 to the electronic circuit device 7, for example, through the ACF.

According to the present Embodiment, the connection between the bump 2 and the bump connecting terminal 32 using the ACF 8 is exemplified. However, the method of connecting the bump 2 to the bump connecting terminal 32 is not limited to this connection method using the ACF 8. For example, the bump 2 may be connected to the bump connecting terminal 32 by an Au-Sn eutectic bonding. If this connection method using the Au-Sn eutectic bonding is used, the bump connecting terminal 32 is plated with Sn, and the bump 2 and the bump connecting terminal 32 are connected to each other by thermal pressure bonding at about 400°C. The Sn plating is melted by heating at about 400°C, and as shown in Fig. 5, an Au-Sn eutectic material 12 is formed between the bump connecting terminal 32 and the bump 2. As a result, the bump connecting terminal 32 is connected to the bump 2 through the Au-Sn eutectic material 12. After that, an underfill 11 having insulating property such as an epoxy resin is injected and cured between the IC chip 1 and the base film 4.

According to the present Embodiment, the cover lay film 6 is arranged on the entire back surface of the circuit board 20a. The cover lay film 6 may have an opening in the IC chip-mounted region. According to this, vapor can be more efficiently released to the outside in the reflow heating step.

According to this Embodiment, three the second wirings 31a are arranged in the IC chip-mounted region. However, three or more the second wirings 31a may be arranged in the IC chip-mounted region. In such a case, the wirings can be more densely arranged. More specifically, in the present Embodiment, in view of the sizes of the IC chip 1 and the second wiring 31a, two to forty the second wirings 31a can be arranged in the IC chip 1-mounted region. As a result, the second wirings 31a can be much more densely arranged at a di stance large enough to prevent generation of the short-circuit between the second wirings 31a.

### "Embodiment 2"

The liquid crystal display device in accordance with Embodiment 2 of the present invention is mentioned below. The liquid crystal display device in accordance with Embodiment 2 is different from that in Embodiment 1, just in the embodiments of the second wiring and the wiring part. Therefore, explanation for the same contents as in Embodiment 1 is omitted in Embodiment 2.

Fig. 6 is a planar view schematically showing a configuration on the second main surface (back surface) side in the IC chip-mounted region and near the IC chip-mounted region of the electronic circuit device in accordance with Embodiment 2. In Fig. 6, the dotted line shows a bump arranged on the first main surface (front surface) and the dashed-dotted line shows an IC chip arranged on the first main surface (front surface) .

In the liquid crystal display device (circuit board 20b) in the present Embodiment, the second wiring 31b is not connected to the wiring part 40b. That is, the wiring part 31b is a dummy wiring electrically insulated with the second wiring 31b. A distance Db between the wiring part 40b and the second wiring 31b is set to be smaller than a distance D2 between the bumps 2. According to this, there is no bump with which neither the wiring part 40b nor the second wiring 31b overlap. Therefore, generation of the edge short-circuit can be sufficiently suppressed.

Every region overlapping with the bump is at least partly overlapped by at least one of the second wiring 31b and the wiring part 40b. Therefore, similarly in Embodiment 1, the disconnection between the bump 2 and the bump connecting terminal 32 can be effectively suppressed.

Further, there is a space between the second wiring 31b and the wiring part 40b, and therefore the short-circuit between the second wirings 31b via the wiring part 40b can be effectively suppressed.

In the present Embodiment, there is a space between the second wiring 31b and the wiring part 40b, and therefore in some bumps, the wiring part 40b or the second wiring 31b overlap with only a part of the bump. However, the base film 4 has a certain strength, normally, that is, has a shape retentivity to pressure. Therefore, the effect of suppressing the edge short-circuit and the disconnection is hardly influenced.

### "Embodiment 3"

A liquid crystal display device in accordance with Embodiment 3 of the present invention is mentioned below. The liquid crystal display device in Embodiment 3 is different from that in Embodiment 1, just in the embodiments of the second wiring and the wiring part. The same contents as in Embodiment 1 are omitted in Embodiment 3.

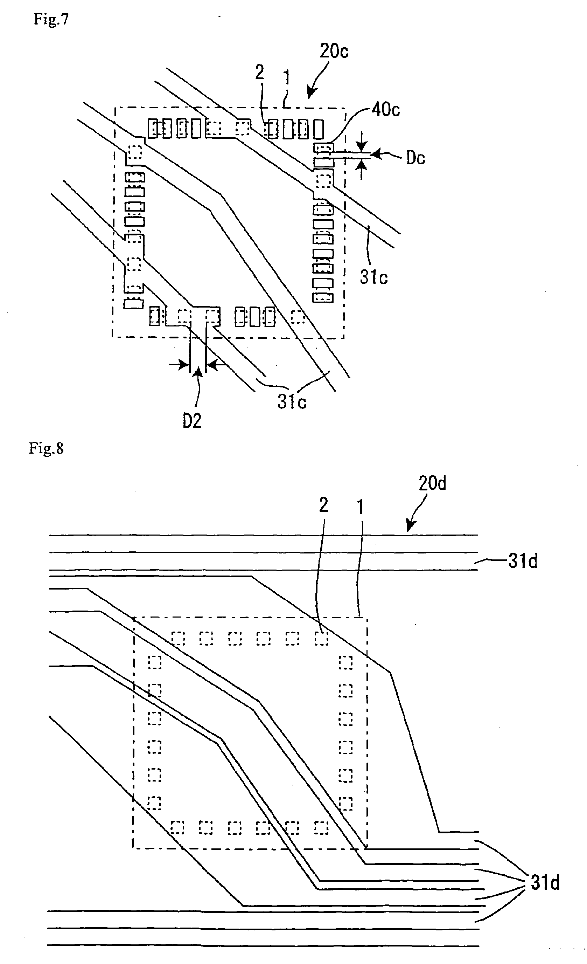

Fig. 7 is a planar view schematically showing a configuration on the second main surface (back surface) side in the IC chip-mounted region and near the IC chip-mounted region of the electronic circuit device in accordance with Embodiment 3. In Fig. 7, the dotted line shows a bump arranged on the first main surface (front surface) and the dashed-dotted line shows an IC chip arranged on the first main surface (front surface) .

The liquid crystal display device (the circuit board 20c) of the present Embodiment includes the second wirings 31c and wiring parts 40c. The wiring parts 40c are arranged with a slit therebetween. That is, a slit is arranged between the wiring parts 40c. A distance Dc between the wiring parts 40c is set to be smaller than a distance D2 between the bumps 2. That is, the wirings 40c are arranged in each region overlapping with the bump 2 when the circuit board 20c is viewed in plane, and the distance between the wirings 40c is smaller than the distance D2. As a result, there is no bump with which neither the wiring part 40c nor the second wiring 31c overlap, and therefore generation of the edge short-circuit can be sufficiently suppressed. That is, according to the present embodiment, every region overlapping with the bump connecting terminal 32 is overlapped by any one or more of the wiring parts 40c when the circuit board 20c is viewed in plane. Further, the distance between the wiring parts 40c is smaller than the distance D2.

Further, in at least a part of every region overlapping with the bump 2, the second wiring 31c and the wiring part 40c are arranged. That is, in every bump 2, either the second wiring 31c or the wiring part 40c is arranged to overlap with at least a part of the bump 2 when the circuit board 20c is viewed in plane. Similarly in Embodiment 1, the disconnection between the bump 2 and the bump connecting terminal 32 can be effectively suppressed.

The wiring parts 40c are arranged with a slit therebetween. Therefore, the short-circuit generated between the second wirings 31c through the wiring part 40c can be effectively suppressed.

The positions of the bump and the bump connecting terminal can be observed through a space between the second wiring 31c and the wiring part 40c, and a space between the wiring parts 40c from the back surface. Therefore, defects including misaligned IC chip 1 can be easily detected.

In the present Embodiment, there is a space between the wiring parts 40c, and therefore in some bumps, at least one of the wiring part 40c and the second wiring 31c overlaps with only a part of the bump. However, the base film 4 has a certain strength, normally, and therefore the effect of suppressing the edge short-circuit and the disconnection is hardly influenced.

In the present Embodiment, the wiring parts 40c are arranged with a distance Dc from one another, and the distance Dc is smaller than the distance D2 between the bumps 2. Therefore, the wiring parts 40c are formed in a high-definition pattern, depending on the size of the bump 2. Even the wiring parts 40c having such a fine pattern can be easily formed if the wirings are formed by an additive method mentioned in Embodiment 1,

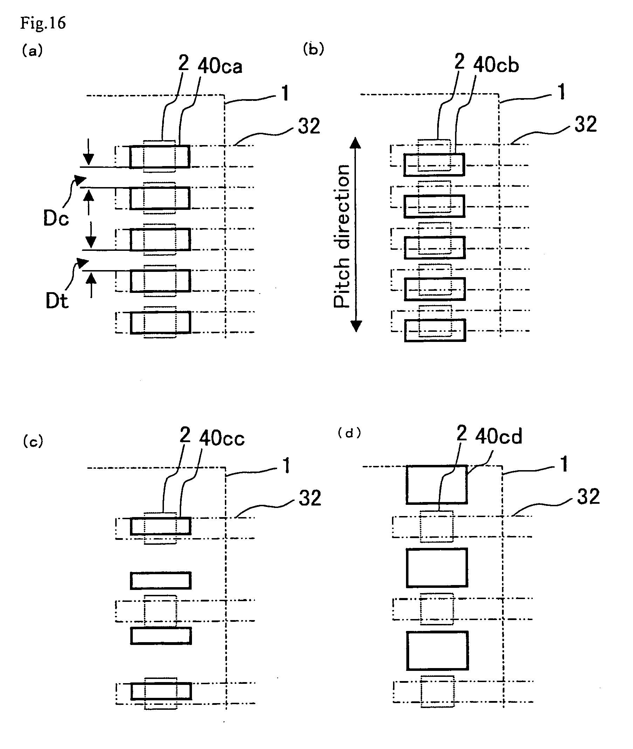

In the present Embodiment, the distance Dc between the wiring parts 40c is set to be smaller than the distance D2 between the bumps 2. However, according to the present Embodiment, a plurality of the wiring parts 40c are arranged at a distance from one another and the distance is not larger than the distance between the bump connecting terminals 32. As shown in Fig. 16 (a), an embodiment in which the distance Dc between the wiring parts 40ca is substantially the same as the distance Dt between the bump connecting terminals 32 may be employed.

In the present Embodiment, as shown in Fig. 16(b), an embodiment in which wiring parts 40cb are arranged not to correspond to the bumps 2 and the bump connecting terminals 32 in the pitch direction may be employed.

Further, according to the present Embodiment, some wiring parts 40cc may overlap with neither the bump 2 nor the bump connecting terminal 32, as shown in Fig. 16(c), as long as a plurality of the wiring parts 40c are arranged at a distance smaller than the distance between the bump connecting terminals 32. Further, as shown in Fig. 16(d), an embodiment in which every wiring part 40cd may overlap with neither the bump 2 nor the bump connecting terminal 32. Even in such embodiment, due to the strength of the base film 4 that is a substrate, the edge short-circuit and the disconnection can be suppressed.

### "Embodiment 4"

The liquid crystal display device in Embodiment 4 of the present invention is mentioned below. The liquid crystal display device in accordance with Embodiment 4 is different from that in Embodiment 1, just in the embodiments of the second wiring and the wiring part. Therefore, the same contents as in Embodiment 1 are omitted in Embodiment 4.

Fig. 8 is a planar view schematically showing a configuration on the second main surface (back surface) side in the IC chip-mounted region and near the IC chip-mounted region of the electronic circuit device in accordance with Embodiment 4. In Fig. 8, the dotted line shows a bump arranged on the first main surface (front surface) and the dashed-dotted line shows an IC chip arranged on the first main surface (front surface) .

The liquid crystal display device (circuit board 20d) in the present Embodiment includes no wiring parts but includes the second wirings 31d, and the second wirings 31d are arranged to overlap with all of the bumps 2. That is, the second wirings 31d are arranged to overlap with all of the bumps 2 when the circuit board 20d is viewed in plane. In other words, every bump 2 is overlapped by any one or more of the second wirings 31d when the circuit board 20d is viewed in plane. As a result, generation of the edge short-circuit can be suppressed. According to the circuit board 20d, the width of each of the second wiring 31d in the IC chip-mounted region is larger than the width of each of the second wiring 31d outside the IC chip-mounted region in order that the each of the thirty-six bumps is overlapped by any one or more of the three the second wirings 31d.

The second wiring 31d is arranged in every region overlapping with the bump 2. Therefore, similarly in Embodiment 1, the disconnection between the bump 2 and the bump connecting terminal 32 can be effectively suppressed.

In the present Embodiment, the second wirings 31d are arrangedto occupymost of the IC chip-mounted region. The second wiring 31d normally includes a metal with a low permeability such as Cu. Accordingly, the liquid crystal display device in the present Embodiment is in accordance with an embodiment disadvantageous in comparison to those in Embodiments 1 to 3, in that vapor can not be efficiently released in the reflow heating step.

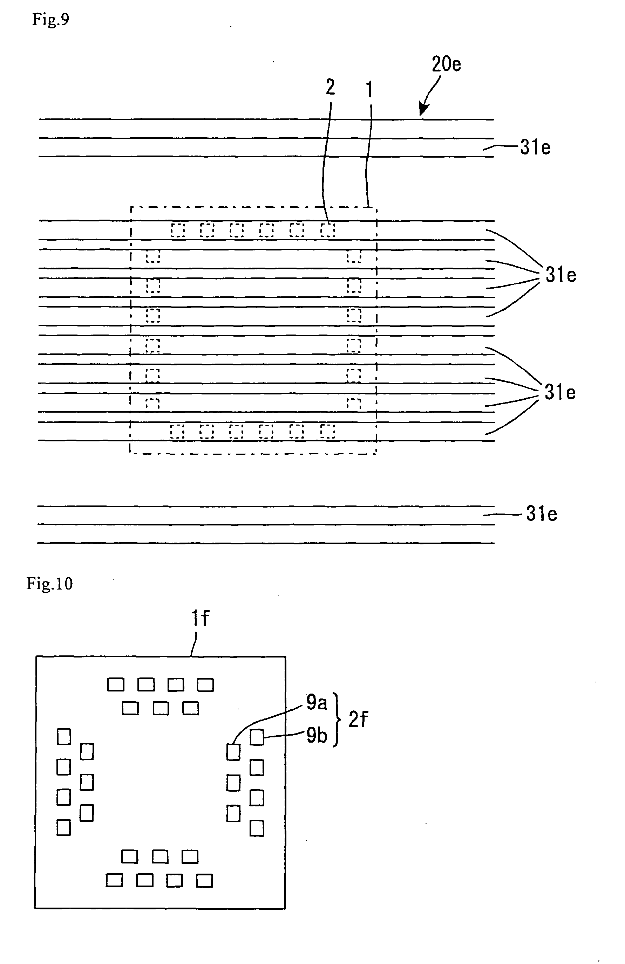

The circuit board according to the present Embodiment may be a circuit board 20e in which every bump 2 is overlapped by any one or more of the second wirings 31e having a substantially uniform width, as shown in Fig. 9.

### "Embodiment 5"

The liquid crystal display device in Embodiment 5 of the present invention is mentioned below. The explanation for the same contents as in Embodiment 5 is omitted in Embodiment 1.

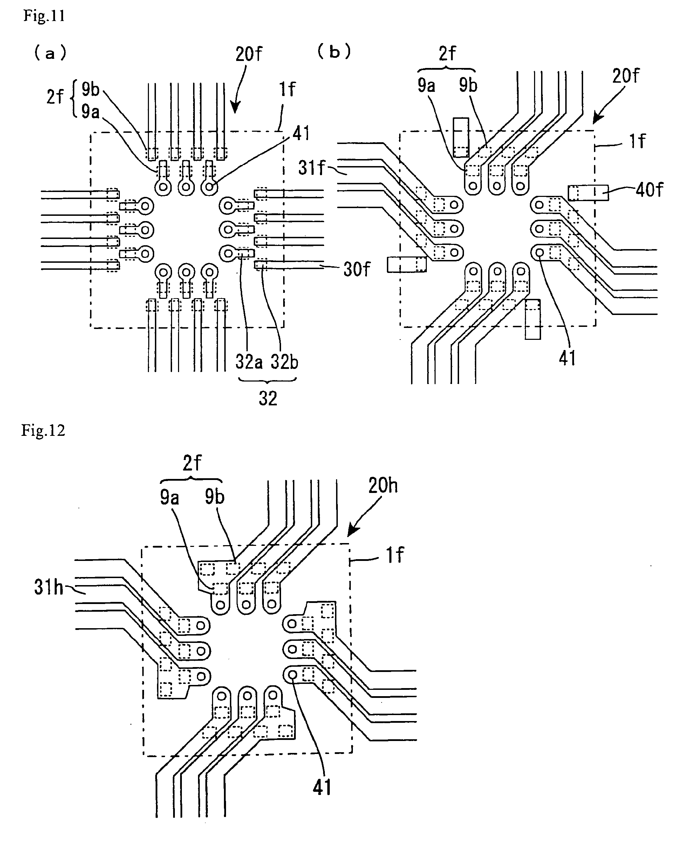

Fig. 10 is a planar view schematically showing a configuration of the bottom surface of an IC chip used in a liquid crystal display device in accordance with Embodiment 5. Fig. 11 is a planar view schematically showing a configuration in the IC chip-mounted region and near the IC chip-mounted region of the electronic circuit device in accordance with Embodiment 5. Fig. 11 (a) shows the first main surface (front surface) side. Fig. 11(b) shows the second main surface (back surface) side. In Fig. 11(a), the dotted line shows a region where the bump is arranged and the dashed-dotted line shows a region where the IC chip is arranged. In Fig. 11(b), the dotted line shows the bump arranged on the first main surface (front surface) and the dashed-dotted line shows the IC chip arranged on the first main surface (front surface).

According to the IC chip 1f in the present Embodiment, as shown in Fig. 10, bumps 2f are arranged in two lines and in a staggered pattern along the periphery of the IC chip 1f. That is, the bumps 2f include inner bumps 9a and outer bumps 9b, and the inner bump 9a and the outer bump 9b are alternately arrayed in a zigzag manner. As a result, the IC chip 1f can be downsized.

The circuit board 20f in the present Embodiment, as shown in Fig. 11(a), includes: inner bump connecting terminals 32a each arranged in a region overlapping with the inner bump 9a; outer bump connecting terminals 32b each arranged in a region overlapping with the outer bump 9b; and through-holes 41 each formed inside of the inner bump connecting terminal 32a.

The outer bump connecting terminal 32b is integrally formed with the first wiring 30f and connected to the first wiring 30f on the front surface of the circuit board 20f. The inner bump connecting terminal 32a is connected to the second wiring 31f on the back surface of the circuit board 20f through the through-hole 41, as shown in Fig. 11(b). Thus, according to the circuit board 20f in accordance with the present Embodiment, generation of defects such as short-circuit between the inner bump connecting terminal 32a and the outer bump connecting terminal 32b is suppressed, and simultaneously a small-size IC chip 1f can be mounted on the circuit board 20f.

The circuit board 20f includes the second wirings 31f and wiring parts 40f. The second wiring 31f is arranged to overlap with the inner bump 9a. The wiring part 40f is arranged to overlap with the outer bump 9b. As a result, generation of the edge short-circuit can be effectively suppressed.

Further, every region which overlaps with the bump 2f (the inner bump 9a and the outer bump 9b) is overlapped by the second wiring 31f or the wiring part 40f. Accordingly, similar in Embodiment 1, the disconnection between the bump 2f and the bump connecting terminal 32 (the inner bump connecting terminal 32a and the outer bump connecting terminal 32b) can be effectively suppressed.

The production method of the liquid crystal display device in accordance with the present Embodiment is mentioned below. The liquid crystal display device in accordance with the present Embodiment can be produced in the same manner as in the production method of the liquid crystal display device in Embodiment 1, except for the through-hole forming step. Accordingly, only a method of forming the through-hole is mentioned below.

The through-hole 41 can be formed through a common through-hole plating technique. That is, the multilayer substrate composed of copper/polyimide/copper, prepared by the method mentioned in Embodiment 1, is provided with holes using a laser beam, a drill, and the like.

Then, a multilayer substrate is immersed in a treatment liquid, and thereby the inner wall of the hole and the entire copper surface of the multilayer substrate are plated with copper. At this time, the entire copper foil surface of the multilayer substrate is also plated with copper, which increases the thickness of the copper foil.

Then, the first and second wiring patterns are formed by PEP process.

In the above-mentioned manners, the circuit board 20f having the through-holes 41 can be prepared.

In the liquid crystal display device in the present Embodiment, the wiring part 40f and the second wiring 31f are not connected to each other, but they may be connected. The liquid crystal display device of the present Embodiment may have, as shown in Fig. 12, an embodiment in which no wiring parts are arranged and every bump 2f is overlapped by any one or more of the second wirings 31h.

The active matrix liquid crystal display device including TFTs as a switching element is mentioned as the liquid crystal display device of the above-mentioned Embodiments, but the display device of the present invention is not limited to a three-terminal element such as a TFT. The display device of the present invention may be an active matrix liquid crystal display device including a two-terminal element such as MIM (Metal Insulator Metal) as a switching element. The display device of the present invention can be applied to a passive (multiplex) driving display device as well as an active driving display device. Further, the display device of the present invention can be applied to any of transmissive, reflective, and transflective display devices.

Additionally, the respective Embodiments may be appropriately combined.

The present application claims priority under the Paris Convention and the domestic law in the country to be entered into national phase on Patent Application No. 2006-69892 filed in Japan on March 14, 2006, the entire contents of which are hereby incorporated by reference.

In the present description, the terms "or more" and "or less" mean that the value described (boundary value) is included.

### BRIEF DESCRIPTION OF DRAWINGS

[Fig. 1]
   Fig. 1 is a planar view schematically showing a configuration on the second main surface (back surface) side in the IC chip-mounted region and near the IC chip-mounted region of the electronic circuit device in accordance with Embodiment 1. In Fig. 1, the dotted line shows the bump arranged on the first main surface (front surface), and the dashed-dotted line shows the IC chip arranged on the first main surface (front surface).
[Fig. 2]
   Fig. 2 is a planar view schematically showing the liquid crystal display device in Embodiment 1.
[Fig. 3]
   Fig. 3 is a cross-sectional view schematically showing the electronic circuit device in Embodiment 1, taken along line PQ in Fig. 1.
[Fig. 4]
   Fig. 4 is a cross-sectional view schematically showing a structure near the edge of the IC chip in the electronic circuit device in accordance with Embodiment 1, and it shows the embodiment where the IC chip is connected to the circuit board using the ACF.
[Fig. 5]
   Fig. 5 is a cross-sectional view schematically showing a structure near the edge of the IC chip in the electronic circuit device in accordance with Embodiment 1, and it shows the embodiment where the IC chip is connected to the circuit board using the Au-Sn eutectic bonding.
[Fig. 6]
   Fig. 6 is a planar view schematically showing a configuration on the second main surface (back surface) side in the IC chip-mounted region and near the IC chip-mounted region of the electronic circuit device in accordance with Embodiment 2. In Fig. 6, the dotted line shows the bump arranged on the first main surface (front surface) and the dashed-dotted line shows the IC chip arranged on the first main surface (front surface).
[Fig. 7]
   Fig. 7 is a planar view schematically showing a configuration on the second main surface (back surface) side in the IC chip-mounted region and near the IC chip-mounted region of the electronic circuit device in accordance with Embodiment 3. In Fig. 7, the dotted line shows the bump arranged on the first main surface (front surface) and the dashed-dotted line shows the IC chip arranged on the first main surface (front surface).
[Fig. 8]
   Fig. 8 is a planar view schematically showing a configuration on the second main surface (back surface) side in the IC chip-mounted region and near the IC chip-mounted region of the electronic circuit device in accordance with Embodiment 4. In Fig. 8, the dotted line shows the bump arranged on the first main surface (front surface) and the dashed-dotted line shows the IC chip arranged on the first main surface (front surface).
[Fig. 9]
   Fig. 9 is a planar view schematically showing another configuration on the second main surface (back surface) side in the IC chip-mounted region and near the IC chip-mounted region of the electronic circuit device in accordance with Embodiment
   4. In Fig. 9, the dotted line shows the bump arranged on the first main surface (front surface) and the dashed-dotted line shows the IC chip arranged on the first main surface (front surface).
[Fig. 10]
   Fig. 10 is a planar view schematically showing a configuration of the bottom surface of the IC chip used in the liquid crystal display device in accordance with Embodiment 5.
[Fig. 11]
   Fig. 11 is a planar view schematically showing a configuration in the IC chip-mounted region and near the IC chip-mounted region of the electronic circuit device in accordance with Embodiment 5. Fig. 11 (a) shows a configuration on the first main surface (front surface) side. Fig. 11 (b) shows a configuration on the second main surface (back surface) side. In Fig. 11(a), the dotted line shows a region where the bump is arranged and the dashed-dotted line shows a region where the IC chip is arranged. In Fig. 11(b), the dotted line shows the bump arranged on the first main surface (front surface) and the dashed-dotted line shows the IC chip arranged on the first main surface (front surface).
[Fig. 12]
   Fig. 12 is a planar view schematically showing another configuration on the second main surface (back surface) side in the IC chip-mounted region and near the IC chip-mounted region of the electronic circuit device in accordance with Embodiment 5. In Fig. 12, the dotted line shows the bump arranged on the first main surface (front surface) and the dashed-dotted line shows the IC chip arranged on the first main surface (front surface).
[Fig. 13]
   Fig. 13 is a planar view schematically showing a configuration on the second main surface (back surface) side of the conventional circuit board. In Fig. 13, the dotted line shows the bump arranged on the first main surface (front surface) and the dashed-dotted line shows the IC chip arranged on the first main surface (front surface).
[Fig. 14]
   Fig. 14 shows a cross-sectional view schematically showing a conventional circuit board in the step of mounting an IC chip on the circuit board shown in Fig. 13, and it shows a state before the IC chip is thermally pressure-bonded. Fig. 14 is a schematic cross-sectional view taken along line X-Y in Fig. 13.
[Fig. 15]
   Fig. 15 is a cross-sectional view schematically showing the conventional circuit board in the step of mounting an IC chip on the circuit board shown in Fig. 13, and it shows a state where the IC chip has been thermally pressure-bonded. Fig. 15 is an enlarged cross-sectional view schematically showing the periphery of the bump in Fig. 14.
[Fig. 16]
   Figs. 16 (a) to (d) are planar view schematically showing another configuration on the second main surface (back surface) side in the IC chip-mounted region and a part of the region near the IC chip-mounted region of the electronic circuit device in accordance with Embodiment 3. In Fig. 16, the dotted line shows the bump, the dashed-dotted line shows the IC chip, and the dashed double-dotted line shows the bump connecting terminal, each arranged on the first main surface (front surface).

### EXPLANATION OF NUMERALS AND SYMBOLS

1, 1f: Integrated circuit (IC chip)
2, 2f, 2g: Bump
4: Base film (Substrate)
5: Resist
6: Cover lay film
6a: Insulating Film
6b: Cohesive layer
7: Electronic circuit device
8: Anisotropic conducting film (ACF)
8a: Conductive particles
8b: Adhesive
9a: Inner bump
9b: Outer bump
10: Liquid crystal display panel
11: Underfill
12: Au-Sn eutectic material
20a, 20b, 20c, 20d, 20e, 20f, 20g, 20h: Circuit board
21: Tip electronic component
22: Driver
30, 30f: The first wiring (front surface wiring)
31a, 31b, 31c, 31d, 31e, 31f, 31g, 31h: The second wiring (back surface wiring)
32: Bump connecting terminal
32a: Inner bump connecting terminal
32b: Outer bump connecting terminal
40a, 40b, 40c, 40ca, 40cb, 40cc, 40cd, 40f: Wiring part
41: Through-hole
50: Space
51: Stage of pressure bonding apparatus
52: Edge of IC chip
100: Liquid crystal display device
D2: Distance between bumps
Db: Distance between wiring part and the second wiring
Dc: Distance between wiring parts
Dt: Distance between bump connecting edges

## Claims

1. A circuit board comprising:
a substrate having a first main surface on which a semiconductor integrated circuit is mounted and a second main surface;
a first wiring including a bump connecting terminal on the first main surface; and
a plurality of second wirings on the second main surface,
wherein the plurality of the second wirings are arranged independently from each other and overlap with a region where the semiconductor integrated circuit is mounted, and
the circuit board includes a wiring part on the second main surface in a region overlapping with a region where the bump connecting terminal is arranged.

2. The circuit board according to Claim 1,
wherein the thickness of the wiring part and the thickness of the plurality of the second wirings are uniformed.

3. The circuit board according to Claim 1,
wherein the wiring part is connected to any one or more of the plurality of the second wirings.

4. The circuit board according to Claim 1,
wherein the wiring part is a dummy wiring independent from the plurality of the second wirings.

5. The circuit board according to Claim 1,
wherein a plurality of the bump connecting terminals are arranged in a plurality of lines along a boundary of the region where the semiconductor integrated circuit is mounted,
the circuit board includes a through-hole, and
an innermost circumference bump connecting terminal is connected to any one of the plurality of the second wirings through the through-hole.

6. The wiring circuit according to Claim 5,
wherein the plurality of the bump connecting terminals are arranged in two or more lines and in a staggered pattern.

7. The wiring circuit according to Claim 5,
wherein the through-hole is arranged on the inside of the innermost circumference bump connecting terminal.

8. A circuit board comprising:
a substrate having a first main surface on which a semiconductor integrated circuit is mounted and a second main surface;
first wirings including bump connecting terminals, respectively, on the first main surface; and
a plurality of second wirings on the second main surface,
wherein the plurality of the second wirings are arranged independently from each other and overlap with a region were the semiconductor integrated circuit is mounted,
the circuit board includes wiring parts on the second main surface side in a region where the bump connecting terminals are arranged, and
the wiring parts are arranged at a distance from one another, the distance being not larger than a distance between the bump connecting terminals.

9. A circuit board comprising:
a substrate having a first main surface on which a semiconductor integrated circuit is mounted and a second main surface;
first wirings including bump connecting terminals, respectively, on the first main surface; and
a plurality of second wirings on the second main surface,
wherein each of the bump connecting terminals is overlapped by any one or more of the plurality of the second wirings.

10. An electronic circuit device comprising:
the circuit board of any one of Claims 1 to 9; and
a semiconductor integrated circuit including a bump connected to the bump connecting terminal.

11. A display device comprising the electronic circuit device of Claim 10.
